# EUROPÄISCHE PATENTSCHRIFT

(11) **EP 0 417 640 B1**
(45) Veröffentlichungstag und Bekanntmachung des Hinweises auf die Patenterteilung: **04.12.1996**
(21) Anmeldenummer: 90117158.7
(22) Anmeldetag: 06.09.1990
(51) Int. Cl.: H01J 37/065, H01J 1/18

(54) **Katodenhalter für einen Elektronenstrahlerzeuger**
Cathode support for election beam producing device
Support de cathode pour dispositif de production de faisceau d'élections

(30) Priorität: 09.09.1989 DE 3930201; 09.09.1989 DE 3930203
(43) Veröffentlichungstag der Anmeldung: 20.03.1991
(73) Patentinhaber: PTR PRÄZISIONSTECHNIK GMBH, 63461 Maintal (DE)
(72) Erfinder: Fritz, Dieter, D-6460 Gelnhausen (DE); Schwarz, Wolfgang, Dr., D-6464 Linsengericht (DE); Spruck, Helmut, D-8031 Gilching (DE)
(74) Vertreter: Sartorius, Peter, Dipl.-Ing.

(56) Entgegenhaltungen:
- EP-A- 0 296 385
- DE-A- 1 232 661
- FR-A- 2 545 993
- US-A- 2 729 800
- US-A- 3 857 055
- US-A- 3 878 424
- US-A- 4 661 741
- US-A- 4 743 201
- PATENT ABSTRACTS OF JAPAN, Band 3, Nr. 155 (E-160), 19. Dezember 1979; & JP-A-54 136 170

## Beschreibung

Die Erfindung betrifft einen Kathodenhalter für einen Elektronenstrahlerzeuger, insbesondere Elektronenstrahlkanone, mit zwei durch einen Isolator voneinander getrennten und isoliert in einem Träger angeordneten Anschlußelementen.

Kontakte dieser Art sind zur Herstellung einer leicht lösbaren, elektrisch leitenden Verbindung allgemein bekannt. In Elektronenstrahlkanonen werden derartige Kontakte unter anderem verwendet, um den Kathodenträger mit den Anschlüssen des Heizstromkreises im sogenannten Strahlkopf zu verbinden. Hierbei ist es seither bekannt, als Kontakte sogenannte Büschel stecker vorzusehen, die am Kathodenträger befestigt sind und mit ihrem Büschel aus federnden Kontaktdrähten in eine am Strahlkopf angeordnete Kontakthülse eingreifen. Die gekannten Büschel stecker ermöglichen eine gute elektrische Kontaktgabe; sie haben aber den Nachteil, daß ihre Wärmeleitfähigkeit und ihre Temperaturbeständigkeit gering sind. Zwar sind auch hochtemperaturbeständige Büschelkontakte auf Nickelbasis bekannt. Bei diesen ist jedoch das Wärmeleitvermögen gering und die Werte der elektrischen Übertragung sind schlecht.

Bei Elektronenstrahlerzeugern ist es für die Einhaltung der Zentrierung und die optimale Fokussierung des Elektronenstrahls erforderlich, daß die Emissionsfläche der Glühkathode genau im Zentrum der Steuerelektrode angeordnet ist und diese Lage während des Betriebs mit hoher Genauigkeit beibehält. Während die Glühkathode hinsichtlich ihrer Raumform eine ausreichend große thermische Stabilität besitzt, um die notwendige Zentrierung zu gewährleisten, führen die durch allmähliches Aufheizen hervorgerufenen Formveränderungen des Kathodenhalters häufig zu einer exzentrischen Verlagerung der Kathodenemissionsfläche, so daß ein Nachjustieren des Elektronenstrahls erforderlich wird.

Ferner ist nach der USA-Patentschrift 4 661 741 (Valun) eine Elektronenstrahlkanone mit einem eine nicht metallische Öffnung aufweisenden Gitter mit einer Oberfläche an der Kathode bekannt, wobei am unteren Ende eine Mutter eingeschraubt ist, die an ihrer Oberfläche die Scheibe trägt. Die Scheibe dient vorzugsweise als Tragelement für die Kathodenelemente. Die Stäbe sowie auch die übrigen Teile sind nicht verstellbar in dem ringartigen Gehäuse aufgenommen.

Aufgabe der Erfindung ist es, einen Kathodenhalter für einen Elektronenstrahlerzeuger zu schaffen, der in allen Betriebszuständen eine genaue Zentrierung der Kathodenemissionsfläche gewährleistet.

Diese Aufgabe wird erfindungsgemäß dadurch gelöst, daß die Anschlußelemente aus beweglichen Bauteilen bestehen und an rotationssymmetrische Mantelflächen angrenzt, deren Zentrum auf der optischen Achse liegt, wobei die beweglichen Bauteile auf einer Bahn verstellbar sind und die optische Achse in einem Winkel schneiden. Hierzu ist es vorteilhaft, daß das Anschlußelement aus beweglichen Bauteilen besteht, die auf einer Bahn verstellbar sind und die optische Achse in einem annähernd rechten Winkel schneiden. Gemäß einer besonderen Ausführungsform der Erfindung ist vorgesehen, daß das Anschlußelement Anschlußklemmem aufweist, die in einer senkrecht zur optischen Achse des Elektronenstrahlerzeugers liegenden Ebene auf Wälz- und/oder Gleitkörpern beweglich gelagert sind.

In weiterer Ausgestaltung der Erfindung ist es vorteilhaft, daß Wälz- und/oder Gleitkörper in Wälz- und/oder Gleitbahnen geführt sind, die die optische Achse in einem annähernd rechten Winkel schneiden und daß beide Anschlußklemmen des Kathodenhalters symmetrisch in einer senkrecht zur optischen Achse des Elektronenstrahlerzeugers liegenden Ebene auf Wälz- oder Gleitkörpern beweglich gelagert sind, die in radial zur optischen Achse verlaufenden Wälz- oder Gleitbahnen geführt sind.

Mit der erfindungsgemäßen Lagerung wird eine in bezug auf die optische Achse symmetrische Ausdehnung der beiden Anschlußklemmen bei Erwärmung bewirkt, so daß die Emissionsfläche der Glühkathode ihre zentrische Lage beibehält. Der erfindungsgemäße Kathodenhalter gewährleistet somit bei allen Temperaturbedingungen während eines Heizzyklus eine exakte Zentrierung der Kathode. Temperaturbedingte Lageänderungen des Elektronenstrahls werden damit vermieden.

Nach einem weiteren Vorschlag der Erfindung können die Wälz- oder Gleitkörper aus einem temperaturbeständigen Isoliermaterial, vorzugsweise aus einem keramischen Werkstoff, bestehen. Auf diese Weise ist es somit möglich, den Bauaufwand und die Herstellkosten zur Isolierung der Anschlußklemmen zu verringern. Die Wälz- oder Gleitkörper sind dabei vorzugsweise optisch gegenüber dem Elektronenstrahl abgedeckt, um zu vermeiden, daß sich Metalldämpfe an ihnen niederschlagen.

Erfindungsgemäß kann weiterhin vorgesehen sein, daß die beiden durch ein Verbindungselement zu einer baulichen Einheit verbundenen Anschlußklemmen jeweils etwa zur Hälfte einen in der zur optischen Achse senkrechten Ebene liegenden ringförmigen Flansch bilden, in den radiale Wälzbahnen bildende Nuten eingearbeitet sind. Weiterhin kann vorgesehen sein, daß die Anschlußklemmen in einem ringförmigen Trägerflansch gelagert sind, der den Nuten im Flansch gegenüberliegende Nuten mit radialen Wälzbahnen aufweist.

Um die Wälz- oder Gleitlagerung spielfrei zu halten, kann erfindungsgemäß weiterhin vorgesehen sein, daß die Anschlußklemmen durch vorgespannte Federn in axialer Richtung, gegen die Wälz- oder Gleitbahnen gedrückt werden. Hierbei können auch die Federn über Wälz- oder Gleitkörper, die in radialen Wälz- oder Gleitbahnen geführt sind, an den Anschlußklemmen abgestützt sein. Dies hat den Vorteil, daß die Übertragung der Federkraft nicht zu Klemmkräften führt, die die symmetrische Ausdehnung der Anschlußklemmen beeinträchtigen. Die Federn können gemäß einem weiteren Vorschlag der Erfindung vorteilhaft aus einzelnen Federzungen bestehen, die an einem gemeinsamen, mit dem Trägerflansch verbindbaren Ring angeordnet sind.

Eine genaue Ausrichtung der beiden Anschlußklemmen zueinander und eine einfache gegenseitige Isolierung der Anschlußklemmen wird nach einem weiteren Vorschlag der Erfindung dadurch erreicht, daß die beiderseits einer in der optischen Achse liegenden Ebene angeordneten Anschlußklemmen über drei Kugeln aus einem temperaturbeständigen Isoliermaterial aneinander abgestützt sind, wobei die Kugeln in trichterförmigen Vertiefungen in den einander zugekehrten Stirnflächen der Anschlußklemmen ruhen und die Anschlußklemmen durch eine isolierte Verbindungsschraube gegen die Kugeln gedrückt werden.

Zwei Ausführungsbeispiele der Erfindung sind in der Zeichnung dargestellt und im folgenden näher beschrieben. Es zeigen:
- Figur 1: einen Querschnitt durch den Strahlerzeuger einer Elektronenstrahlkanone mit einem erfindungsgemäßen Kathodenhalter,

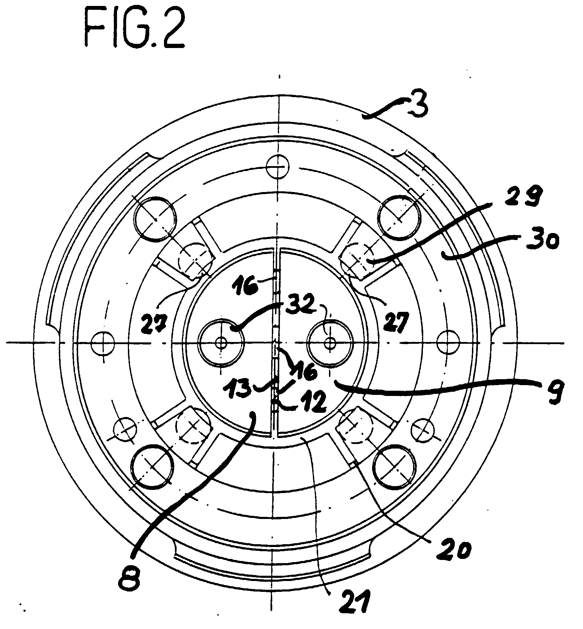

- Figur 2: eine Draufsicht auf den mit seinem Lagerring aus dem Strahlerzeuger ausgebauten Kathodenhalter gemäß Figur 1,
- Figur 3: einen Längsschnitt durch den Strahlerzeuger einer Elektronenstrahlkanone mit einer Ausführungsform des erfindungsgemäßen Kontakts,
- Figur 4: einen Längsschnitt durch eine andere Ausführungsform eines erfindungsgemäßen Kontakts,
- Figur 5: einen Querschnitt gemäß Figur 4.

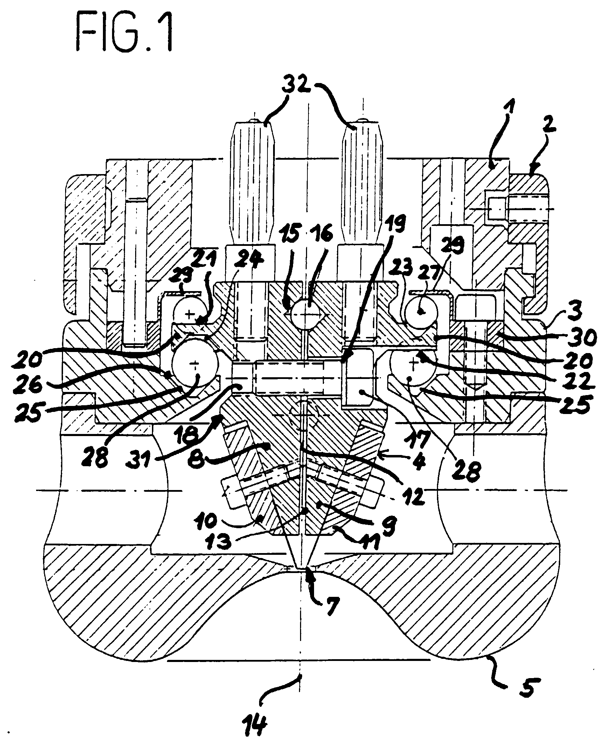

In Figur 1 ist der am unteren Ende eines Hochspannungsisolators angeordnete Strahlerzeuger einer Elektronenstrahlkanone dargestellt. Die Bauteile des Strahlerzeugers werden von einem Befestigungsflansch 1 getragen, der mit dem nicht abgebildeten Hochspannungsisolator verbunden ist und einen Bajonettring 2 aufweist. An dem Befestigungsflansch 1 ist mit Hilfe des Bajonettrings 2 ein ringförmiger Trägerflansch 3 lösbar befestigt, in dem der Kathodenhalter 4 gelagert ist. An der Unterseite des Trägerflanschs 3 ist über Zentrierflächen ausgerichtet eine strahlformende Steuerelektrode 5 befestigt, die mit ihrer zentrischen Öffnung das untere Ende einer am Kathodenhalter 4 angeordneten Glühkathode 7 umgibt.

Der Kathodenhalter 4 besteht aus zwei im wesentlichen spiegelgleich ausgebildeten Anschlußklemmen 8,9, die an ihren unteren Enden Klemmschuhe 10,11 zum Befestigen der beiden Enden der Glühkathode 7 aufweisen. Die beiden Anschlußklemmen 8,9 kehren einander ebene und im wesentlichen parallel zueinander ausgerichtete Flächen 12,13 zu, die sich beiderseits in der optischen Achse 14 des Strahlerzeugers befinden. In den Flächen 12,13 sind drei einander gegenüberliegende, trichterförmige Vertiefungen 15 ausgebildet, in denen Kugeln 16 aus einem keramischen Isoliermaterial angeordnet sind, die zwischen den Flächen 12,13 einen Isolierabstand aufrechterhalten. Die Kugeln 16 sorgen dabei gleichzeitig für eine genau definierte Ausrichtung der beiden Anschlußklemmen 8,9 zueinander. Im Zentrum des durch die Kugeln 16 beschriebenen Dreiecks ist eine Verbindungsschraube 17 vorgesehen, die in eine Gewindebohrung 18 in der Anschlußklemme 8 eingeschraubt ist und deren Kopf über eine Isolierscheibe 19 an der Anschlußklemme 9 abgestützt ist. Durch die Verbindungsschraube 17 werden die beiden Anschlußklemmen 8,8 zusammengehalten und mit ihren trichterförmigen Vertiefungen 15 gegen die Kugeln 16 gedrückt. Die beiden Anschlußklemmen 8,9 sind auf diese Weise zu einem starren Bauteil miteinander verbunden, elektrisch jedoch voneinander getrennt.

An die Flächen 12,13 der Anschlußklemmen 8,9 grenzen rotationssymmetrische Mantelflächen an, deren Zentrum auf der optischen Achse 14 liegt. Mit diesen Flächen bildet jede Anschlußklemme 8,9 jeweils eine Hälfte eines ringförmigen Flansches 20, mit dem der Kathodenhalter 4 in den Trägerflansch 3 gelagert ist. Hierzu weist der Flansch 20 in seinen beiden kreisringförmigen Seitenflächen 21,22 Nuten 23,24 auf, die radial zu dem durch die optische Achse 14 gebildeten Zentrum ausgerichtete Wälzbahnen geringer Länge bilden. Die Nuten 23 in der Seitenfläche 21 sind gegenüber den Nuten 24 in der Seitenfläche 22 versetzt angeordnet. Den Nuten 24 in der Seitenfläche 22 liegen Nuten 25 in einer Kreisringfläche 26 des Flanschrings 3 gegenüber, die ebenfalls radial zum Zentrum der optischen Achse 14 ausgerichtete Wälzbahnen bilden. In den Nuten 23 sind Kugeln 27 und in den Nuten 24,25 sind Kugeln 28 angeordnet. Die Kugeln 27,28 bestehen aus einem keramischen Isoliermaterial und isolieren den Kathodenhalter 4 gegenüber der am Tragflansch 3 anliegenden Wehnelt- Spannung. Auf den Kugeln 27 ruhen vorgespannte Federzungen 29, die an einem mit dem Tragring 3 verschraubten Ring 30 angeordnet sind, der den Flansch 20 mit Abstand umgibt. Hierdurch wird die durch die Kugeln 27,28 gebildete Lagerung in axialer Richtung verspannt und zusammengehalten. Auf der der Glühkathode zugekehrten Seite ist die Öffnung im Tragflansch 3 optisch durch einen von den Mantelflächen der Anschlußklemmen 8,9 gebildeten Bund 31 abgedeckt, um ein Bedampfen der Kugeln 27,28 zu vermeiden.

Durch die beschriebene Lagerung wird der durch die beiden Anschlußklemmen 8,9 gebildete Kathodenhalter 4 im Tragflansch 3 zentriert, wobei er sich unabhängig vom Tragflansch 3 bei Erwärmung ausdehnen kann, ohne daß die Zentrierung dadurch beeinträchtigt wird. Dies ist Voraussetzung für die konstante Brennflecklage am Werkstück. Gleichzeitig sorgt die beschriebene Lagerung auf einfache Weise für die erforderliche Isolierung des Kathodenhalters 4 gegenüber der Steuerelektrode 3. Die Abstützung der beiden Anschlußklemmen 8,9 über die Kugeln 16 bewirkt ebenfalls auf einfache Weise eine Isolierung und sorgt für eine genaue Positionierung der beiden Hälften des Flansches 20 zueinander, damit die genaue Zentrierung des Kathodenhalters 4 gewährleistet ist. Eine hohe Genauigkeit der Teile läßt sich beispielsweise dadurch erreichen, daß der Flansch 20 und die in seinen Seitenflächen 21,22 ausgebildeten Nuten 23,24, nachdem die beiden Anschlußklemmen 8,9 über die Kugeln 16 und die Verbindungsschraube 17 miteinander verbunden worden sind, in einer Aufspannung bearbeitet werden.

Auf ihrer von der Glühkathode 7 abgekehrten Seite weisen die Anschlußklemmen 8,9 Büschelstecker 32 auf, mit denen sie an den Heizstromkreis der Elektronenstrahlkanone anschließbar sind.

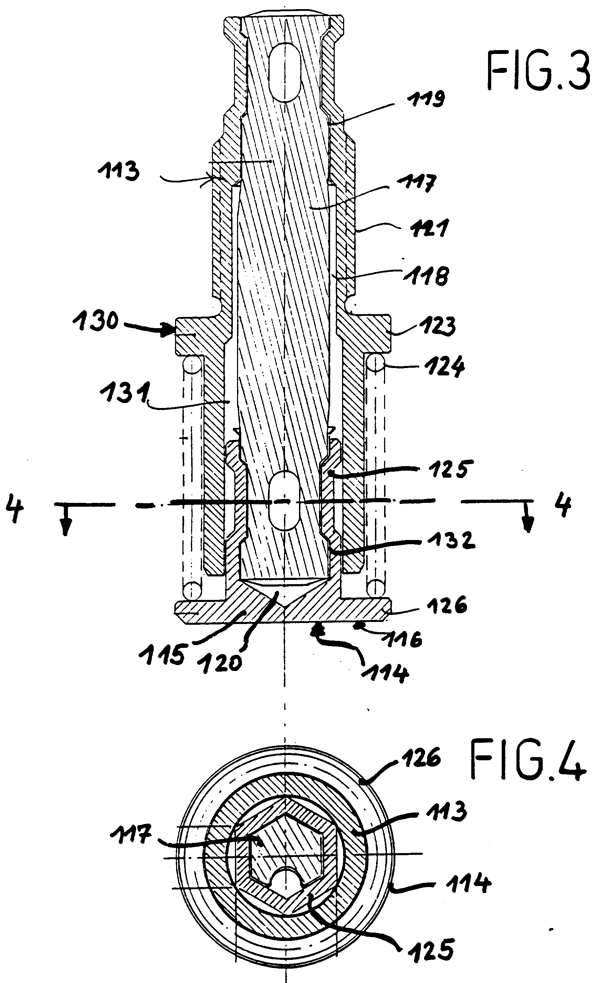

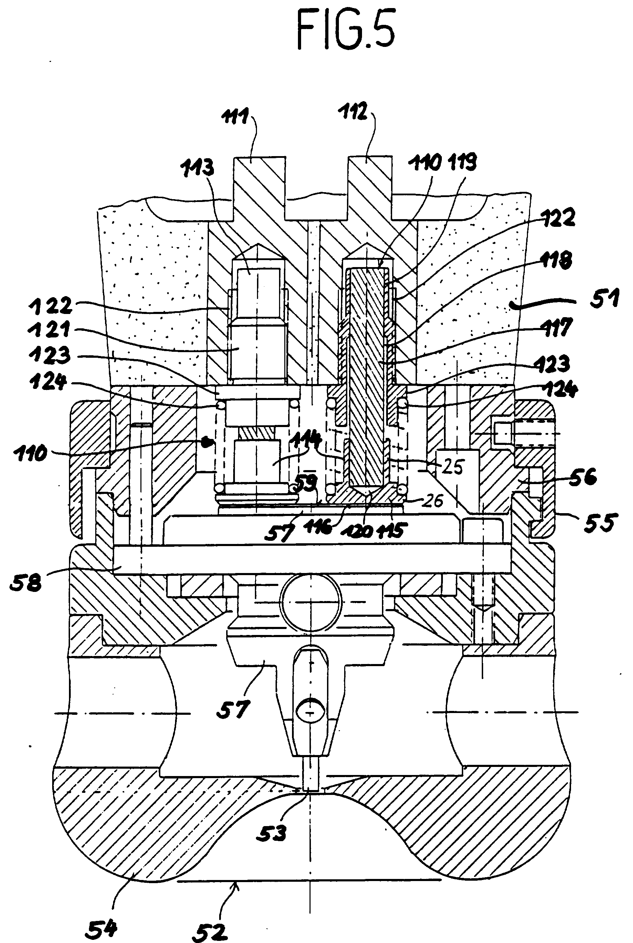

Figur 4 zeigt einen Querschnitt entlang der Linie 4-4 in Figur 3. Figur 1 zeigt den um unteren Ende eines weiteren Ausführungsbeispiels eines Hochspannungsisolators 51 des Strahlkopfs einer Elektronenstrahlkanone angeordneten Strahlerzeuger 52 mit einer Kathode 53 und einer strahlformenden Steuerelektrode 54, die mit einem Bajonettring 55 an einem Befestigungsflansch 56 lösbar befestigt ist. Die Kathode 53 ist an einem Kathodenträger 57 angeordnet, der mit einem Isolierlager 58 in der Steuerelektrode 54 gelagert ist. Auf seiner dem Befestigungsflansch 56 zugekehrten Seite weist der Kathodenträger 57 zwei ebene, durch einen Isolator voneinander getrennte Gegenkontaktflächen 59 auf, die jeweils mit einem Pol der Kathode 53 in Verbindung stehen. Jede Kontaktfläche 59 ist über einen Kontakt 110 an eine im Hochspannungsisolator 51 angeordnete Anschlußklemme 111 bzw. 112 des Heizstromkreises der Elektronenstrahlkanone angeschlossen.

Die Kontakte 110 bestehen aus einem hülsenförmigen Anschlußelement 113, einem in Form eines Topfes ausgebildeten Kontaktelement 114, dessen Boden 115 eine ebene Kontaktfläche 116 aufweist, und einem das Anschlußelement 113 mit dem Kontaktelement 114 verbindenden, flexiblen Leiter 117, der aus einer Kupferlitze besteht. Der Leiter 117 erstreckt sich durch die Bohrung 118 im Anschlußelement 113 hindurch und ist nur mit seinem Ende in einem Bohrungsabschnitt 119 kleineren Durchmessers des Anschlußelements 113 befestigt. Das entgegengesetzte Ende des Leiters 117 ist in der Bohrung 120 im Kontaktelement 114 befestigt. In seinem mittleren Bereich ist das Anschlußelement 113 mit einem Außengewinde 121 versehen, mit dem es in eine Gewindebohrung 122 einer Anschlußklemme 111 bzw. 112 eingeschraubt ist. Ein Ringbund 123 auf der Außenseite des Anschlußelements 113 begrenzt die Einschraubtiefe und bildet mit seiner Rückseite eine Anlagefläche für eine Schraubendruckfeder 124, die zwischen dem Anschlußelement 113 und dem Kontaktelement 114 eingespannt ist. Am Kontaktelement 114 ist die Schraubendruckfeder 124 an einem über die zylindrische Wand 125 des Kontaktelements 114 hinausragenden Rand 126 des Bodens 115 abgestützt. Die Schraubendruckfeder 124 wird bei der Herstellung der Kontakte 110 mit einer solchen Vorspannung versehen, daß sie in der zusammengedrückten Einbaulage der Kontakte 110 im Strahlerzeuger 52 den erforderlichen Kontaktdruck zwischen den Kontaktflächen 59 und 116 erzeugt.

Wie die Darstellung zeigt, ist das Kontaktelement 114 ausschließlich über flexible Mittel, nämlich den Leiter 117 und die Schraubendruckfeder 124 mit dem Anschlußelement 113 verbunden. Es kann daher den thermischen Verformungbewegungen des Kathodenträgers 57 uneingeschränkt folgen, so daß die zentrische Lage der Kathode 53 nicht beeinträchtigt wird. Die Schraubendruckfeder 124 ist in ihrer Wirkung außerdem einem Kardangelenk vergleichbar und gewährleistet immer eine vollflächige Anlage des Kontaktelements 114 am Kathodenträger 57. Durch die beschriebene Anordnung läßt sich der Kathodenträger 57 zusammen mit der Steuerelektrode 54 einfach aus- und einbauen. Die Befestigung der Kontakte 110 am Hochspannungsisolator 51 vereinfacht den Aufbau des Kathodenträgers 57 und erleichtert Wartungsarbeiten wie zum Beispiel das Auswechseln der Kathode 53, bei denen der Kathodenträger 57 ausgebaut wird. Auch die Gefahr einer Beschädigung der Kontakte 110 ist gering. Durch die großflächige Anlage der Kontaktelemente 114 am Kathodenträger 57 und das gute Wärmeleitverhalten der Kontakte 110 wird weiterhin eine wirksame Kühlung des Kathodenträgers 57 und eine Herabsetzung seiner Betriebstemperatur erreicht.

Der in den Figuren 3 und 4 dargestellte Kontakt 130 unterscheidet sich nur in einigen Einzelheiten von dem in Figur 5 dargestellten Kontakt 110. Für einander entsprechende Bauteile wurden daher gleiche Bezugszeichen verwendet.

Bei dem Kontakt 130 ragt der Topf 125 des Kontaktelements 114 in einen erweiterten Bohrungsabschnitt 131 des Anschlußelements 113 hinein und ist lose im Anschlußelement 113 geführt. Dies ist zweckmäßig, wenn die Gegenkontaktfläche beim Heranführen des Gegenkontakts unter Zusammendrückung der Schraubendruckfeder 124 um einen nennenswerten Betrag quer zur Längsachse des Kontakts 130 bewegt wird, um eine seitliche Verlagerung des Kontaktelements 114 und ein Ausknicken der Schraubendruckfeder 124 zu vermeiden. Der Leiter 117 ist bei dem Kontakt 130 durch plastische Verformung der Wand 125 und des Bohrungsabschnitts 119 festgeklemmt. Hierbei wird zunächst das mit einer Schutzhülse 132 versehene Ende des aus einer Drahtlitze bestehenden Leiters 117 in die Bohrung 120 des Kontaktelements 114 gesteckt. Anschließend wird die Wand 125 radial von außen in der in Figur 3 ersichtlichen Weise zusammengedrückt, wodurch sich eine sechseckige Querschnittsform ergibt. Um die Litze im Bereich dieser Einspannstelle noch zu verdichten, wird zum Schluß mit einem stumpfen Werkzeug zusätzlich ein Wandabschnitt 133 der Wand 125 derart eingedrückt, daß eine nach innen gerichtete Beule entsteht. Durch diesen Vorgang wird eine mechanische Verbindung zwischen dem Leiter 117 und dem Kontaktelement 114 hergestellt, die sich durch eine gute elektrische und thermische Leitfähigkeit auszeichnet. Ist der Leiter 117 mit dem Kontaktelement 114 verbunden, so werden die Schraubendruckfeder 124 und das Anschlußelement 113 montiert, wobei die Schraubendruckfeder 124 auf die vorgegebene Länge zusammengedrückt wird. In dieser Montageposition wird dann der Leiter 117 in der gleichen Weise wie mit dem Kontaktelement 114 durch plastische Verformung mit dem Anschlußelement 113 verbunden.

## Patentansprüche

1. Kathodenhalter (4) für einen Elektronenstrahlerzeuger, insbesondere Elektronenstrahlkanone, mit zwei durch einen Isolator voneinander getrennten und isoliert in einem Träger angeordneten Anschlußelementen (8, 9), **dadurch gekennzeichnet**, daß die Anschlußelemente (8,9) aus beweglichen Bauteilen bestehen, und an rotationssymmetrische Mantelflächen angrenzen, deren Zentrum auf der optischen Achse 14 liegt, wobei die beweglichen Bauteile auf einer Bahn verstellbar sind und die optische Achse (14) in einem spitzen Winkel schneiden.

2. Kathodenhalter nach Anspruch 1, **dadurch gekennzeichnet**, daß das Anschlußelement (8,9,) aus beweglichen Bauteilen besteht, die auf einer Bahn verstellbar sind und die optische Achse (14) in einem annähernd rechten Winkel schneiden.

3. Kathodenhalter nach Anspruch 1, **dadurch gekennzeichnet**, daß das Anschlußelement Anschlußklemmem (8,9,) aufweist, die in einer senkrecht zur optischen Achse (14) des Elektronenstrahlerzeugers liegenden Ebene auf Wälz- und/oder Gleitkörpern (27,28) beweglich gelagert sind.

4. Kathodenhalter nach Anspruch 1, **dadurch gekennzeichnet**, daß die Wälz- und/oder Gleitkörper (27,28) in Wälz- und/oder Gleitbahnen (24 bis 25) geführt sind, die die optische Achse in einem annähernd rechten Winkel schneiden.

5. Kathodenhalter nach Anspruch 1, **dadurch gekennzeichnet**, daß beide Anschlußklemmen (8,9) des Kathodenhalters (4) symmetrisch in einer senkrecht zur optischen Achse des Elektronenstrahlerzeugers liegenden Ebene auf Wälz- oder Gleitkörpern (27,28) beweglich gelagert sind, die in radial zur optischen Achse (14) verlaufenden Wälz- oder Gleitbahnen (27,28) geführt sind.

6. Kathodenhalter nach einem oder mehreren der vorhergehenden Ansprüche, **dadurch gekennzeichnet, daß** die Wälz- oder Gleitkörper (27,28) aus einem temperaturbeständigen Isoliermaterial, vorzugsweise aus einem keramischen Werkstoff, bestehen.

7. Kathodenhalter nach einem oder mehreren der vorhergehenden Ansprüche, **dadurch gekennzeichnet, daß** die Wälz- oder Gleitkörper (27,28) optisch gegenüber dem Elektronenstrahl abgedeckt sind.

8. Kathodenhalter nach einem der vorhergehenden Ansprüche **dadurch gekennzeichnet, daß** die beiden durch ein Verbindungselement (16,17) zu einer baulichen Einheit verbundenen Anschlußklemmen (8,9) jeweils etwa zur Hälfte einen in der zur optischen Achse (14) senkrechten Ebene liegenden, ringförmigen Flansch (20) bilden, in den radiale Wälzbahnen bildende Nuten (23,24) eingearbeitet sind.

9. Kathodenhalter nach einem oder mehreren der vorhergehenden Ansprüche, **dadurch gekennzeichnet, daß** die beiden Anschlußkklemmen (8,9) in einem ringförmigen Trägerflansch (3) gelagert sind, der den Nuten (24) im Flansch (20) gegenüberliegende Nuten (25) mit radialen Wälzbahnen aufweist.

10. Kathodenhalter nach einem oder mehreren der vorhergehenden Ansprüche, **dadurch gekennzeichnet, daß** die Anschlußklemmen (8,9) durch vorgespannte Federn (29) in axialer Richtung gegen die Wälz- oder Gleitkörper (27,28) gedrückt werden.

11. Kathodenhalter nach einem oder mehreren der vorhergehenden Ansprüche, **dadurch gekennzeichnet, daß** die Federn (29) über Wälz- oder Gleitbahnen (23) geführt sind und an den Anschlußklemmen (8,9) abgestützt sind.

12. Kathodenhalter nach einem oder mehreren der vorhergehenden Ansprüche, **dadurch gekennzeichnet, daß** die Federn aus einzelnen Federzungen (29) bestehen, die an einem gemeinsamen, mit dem Trägerflansch verbindbaren Ring (30) angeordnet sind.

13. Kathodenhalter nach einem der vorhergehenden Ansprüche, **dadurch gekennzeichnet, daß** die beiderseits einer in der optischen Achse (14) liegenden Ebene angeordneten Anschlußklemmen (8,9) über drei Kugeln (16) aus einem temperaturbeständigen Isoliermaterial aneinander abgestützt sind, wobei die Kugeln (16) in trichterförmige Vertiefungen (15) in den einander zugekehrten Stirnflächen (12,13) der Anschlußklemmen (8,9) ruhen und die Anschlußklemmen (8,9) mittels einer isolierten Verbindungsschraube (17) an die Kugeln (16) angedrückt werden.

## Claims

1. Cathode support (4) for an electron beam generator, particularly for an electron gun, comprising two connecting elements (8, 9) separated from each other by an insulator and arranged in a carrier so as to be insulated, **characterized in that** the connecting elements (8, 9) consist of movable components which are adjacent to rotation-symmetrical lateral areas, whose center lies on the optical axis (14), whereby the movable components are adjustable on a path and intersect the optical axis (14) at an acute angle.

2. Cathode support according to Claim 1, **characterized in that** the connecting element (8, 9) consists of movable components which are adjustable on a path and which intersect the optical axis at an approximately right angle.

3. Cathode support according to Claim 1, **characterized in that** the connecting element has connection terminals (8, 9) which are movably supported on rolling and/or gliding elements (27, 28) in a plane that is perpendicular to the optical axis (14) of the electron beam generator.

4. Cathode support according to Claim 1, **characterized in that** the rolling and/or gliding elements (27, 28) are positioned in rolling and/or gliding tracks (24 to 25) which intersect the optical axis (14) at an approximately right angle.

5. Cathode support according to Claim 1, **characterized in that** the two connection terminals (8, 9) of the cathode support (4) are supported movably and symmetrically in a plane that is perpendicular to the optical axis of the electron beam generator on rolling and/or gliding elements (27, 28) that are positioned in rolling or gliding tracks (27, 28) that run radially to the optical axis (14).

6. Cathode support according to one or more of the preceding Claims, characterized in that the rolling and/or gliding elements (27, 28) are made of a temperature-stable insulation material, preferably of a ceramic material.

7. Cathode support according to one or more of the preceding Claims, characterized in that the rolling and/or gliding elements (27, 28) are optically shielded from the electron beam.

8. Cathode support according to one or more of the preceding Claims, characterized in that, in the case of the two connection terminals (8, 9) which are joined to form one structural unit by means of a connection element (16, 17), about half of each terminal forms an annular flange (20) that lies in the plane perpendicular to the optical axis (14); grooves (23, 24) forming radial rolling tracks are machined into these flanges.

9. Cathode support according to one or more of the preceding Claims, characterized in that the two connection terminals (8, 9) are supported in an annular carrier flange (3) that has grooves (24) with radial rolling tracks opposite from the grooves (25) in the flange (20).

10. Cathode support according to one or more of the preceding Claims, characterized in that the connection terminals (8, 9) are pressed in the axial direction against the rolling or gliding tracks (27, 28) by means of pre-tensioned springs (29).

11. Cathode support according to one or more of the preceding Claims, characterized in that the springs (29) are positioned via rolling or gliding tracks (23) and are supported on the connection terminals (8, 9).

12. Cathode support according to one or more of the preceding Claims, characterized in that the springs consist of individual spring tongues (29) which are arranged on a shared ring (30) that can be connected to the carrier flange.

13. Cathode support according to one or more of the preceding Claims, characterized in that the connection terminals (8, 9) arranged on both sides of a plane lying in the optical axis (14) are supported on each other by means of three spheres (16) made of a temperature-stable insulation material, whereby the spheres (116) rest in funnel-shaped indentations (15) in the opposing end surfaces (12, 13) of the connection terminals (8, 9) and the connection terminals (8, 9) are pressed against the spheres (16) by an insulated connection screw (17).

## Revendications

1. Porte-cathode (4) pour un générateur de faisceau électronique, notamment un canon à électrons, comportant deux éléments de raccordement (8,9) séparés l'un de l'autre par un isolateur et disposés de façon isolée dans un support, **caractérisé en ce que** les éléments de raccordement (8,9) sont constitués par des composants mobiles et sont limitrophes de surfaces d'enveloppe à symétrie de révolution dont le centre se trouve sur l'axe optique (14), les composants mobiles pouvant être déplacés sur une trajectoire et coupant l'axe optique (14) sous un angle aigu.

2. Porte-cathode suivant la revendication 1, **caractérisé en ce que** l'élément de raccordement (8,9) est constitué par des composants mobiles pouvant être déplacés sur une trajectoire et coupant l'axe optique (14) sous un angle approximativement droit.

3. Porte-cathode suivant la revendication 1, **caractérisé en ce que** l'élément de raccordement présente des bornes de connexion (8,9) qui sont logées de façon mobile sur des corps roulants et/ou glissants (27,28) dans un plan s'étendant perpendiculairement par rapport à l'axe optique (14) du générateur de faisceau électronique.

4. Porte-cathode suivant la revendication 1, **caractérisé en ce que** les corps roulants et/ou glissants (27,28) sont guidés dans des guides de roulement et/ou de glissement (24 à 25) coupant l'axe optique sous un angle approximativement droit.

5. Porte-cathode suivant la revendication 1, **caractérisé en ce que** les deux bornes de connexion (8,9) du porte-cathode (4) sont logées symétriquement dans un plan s'étendant perpendiculairement par rapport à l'axe optique du générateur de faisceau électronique et sont disposées de façon mobile sur des corps roulants ou glissants (27,28) qui sont guidés dans des guides de roulement ou de glissement (27,28) s'étendant dans le sens radial par rapport à l'axe optique (14).

6. Porte-cathode suivant l'une quelconque ou plusieurs des revendications précédentes, **caractérisé en ce que** les corps roulants ou glissants (27,28) consistent en matière isolante thermostable, de préférence en matière céramique.

7. Porte-cathode suivant l'une quelconque ou plusieurs des revendications précédentes, **caractérisé en ce que** les corps roulants ou glissants (27,28) sont masqués optiquement par rapport au faisceau électronique.

8. Porte-cathode suivant l'une quelconque des revendications précédentes, **caractérisé en ce que** les deux bornes de connexion (8,9) reliées par un élément de raccordement (16,17) de façon à former une unité constructive, forment, chacune environ à moitié, une bride annulaire (20) s'étendant perpendiculairement par rapport à l'axe optique (14) et dans laquelle sont pratiquées des rainures (23,24) formant des guides de roulement radiaux.

9. Porte-cathode suivant l'une quelconque ou plusieurs des revendications précédentes, **caractérisé en ce que** les deux bornes de connexion (8,9) sont logées dans une bride de support annulaire (3) laquelle présente des rainures (25) avec des guides de roulement radiaux situées en regard des rainures (24) prévues dans la bride (2).

10. Porte-cathode suivant l'une quelconque ou plusieurs des revendications précédentes, **caractérisé en ce que** les bornes de connexion (8,9) sont serrées contre les corps roulants ou glissants (27,28) dans le sens axial par des ressorts précontraints (29).

11. Porte-cathode suivant l'une quelconque ou plusieurs des revendications précédentes, **caractérisé en ce que** les ressorts (29) sont guidés sur des guides de roulement ou de glissement (23) et s'appliquent contre les bornes de connexion (8,9).

12. Porte-cathode suivant l'une quelconque ou plusieurs des revendications précédentes, **caractérisé en ce que** les ressorts sont composés de lames individuelles (29) disposées sur un anneau commun (30) pouvant être relié à la bride de support.

13. Porte-cathode suivant l'une quelconque des revendications précédentes, **caractérisé en ce que** les bornes de connexion (8,9) disposées de part et d'autre d'un plan situé dans l'axe optique (14) s'appliquent l'une contre l'autre par l'intermédiaire de trois billes (16) en matière isolante thermostable, ledites billes (16) étant logées dans des creux en forme d'entonnoir (15) pratiqués dans les faces frontales (12,13) des bornes de connexion (8,9) et les bornes de connexion (8,9) étant serrées contre les billes (16) au moyen d'une vis de jonction (17) isolée.
